# EUROPEAN PATENT SPECIFICATION

(11) **EP 3 163 685 B1**
(45) Date of publication and mention of the grant of the patent: **19.06.2019**
(21) Application number: 15191430.6
(22) Date of filing: 26.10.2015
(51) Int. Cl.: H01R 13/53, H01R 13/52, H01R 43/18

(54) **PROTECTIVE COVER AND ELECTRICAL CONNECTOR HAVING A RADIATION WINDOW FORMED BY A PLURALITY OF RADIATION PASSAGES**
SCHUTZABDECKUNG UND ELEKTRISCHER VERBINDER MIT STRAHLUNGSFENSTER, DAS DURCH EINE VIELZAHL VON STRAHLUNGSDURCHGÄNGEN AUSGEBILDET IST
COUVERCLE DE PROTECTION ET CONNECTEUR ÉLECTRIQUE COMPRENANT UNE FENÊTRE DE RAYONNEMENT CONSTITUÉE D'UNE PLURALITÉ DE PASSAGES DE RAYONNEMENT

(43) Date of publication of application: 03.05.2017
(73) Proprietor: Tyco Electronics Raychem GmbH, 85521 Ottobrunn (DE); TE Connectivity Germany GmbH, 64625 Bensheim (DE)
(72) Inventor: Mikli, Norbert, 85560 Ebersberg (DE); Kehl, Ladislaus, 81739 München (DE)
(74) Representative: Grünecker Patent- und Rechtsanwälte PartG mbB

(56) References cited:
- US-A1- 2006 110 983
- US-A1- 2010 093 211
- US-A1- 2012 021 650
- US-A1- 2013 032 576
- US-A1- 2013 206 728

## Description

The present invention relates to a protective cover for an electric component and to a method of fabricating such a protective cover. Furthermore, the present invention relates to an electrical connector assembly, in particular a high-voltage connector assembly, which uses a protective cover according to the present invention, and to a method of monitoring the connected status of such an electrical connector assembly.

The term "high-voltage" as used in the following is intended to relate to voltages above approximately 1 kV. In particular, the term high-voltage is intended to comprise the usual nominal voltage ranges of power transmission, namely medium voltage (about 3 kV to about 50 kV), high-voltage (about 50 kV to about 400 kV and higher). Of course also higher voltages may be considered in the future. These voltages may be direct current (DC) or alternating current (AC) voltages. In the following, the term "high-voltage cable" is intended to signify a cable that is suitable for carrying electric current of more than about 1 A at a voltage above approximately 1 kV.

Safety rules require that before maintenance work on medium voltage (MV) and high voltage (HV) equipment is carried out, the status of the equipment has to be checked. The equipment has to be de-energized and/or disconnected and then grounded. In order to avoid critical situations during grounding, the status of a contact pin of an electrical breaker has to be visually checked before the grounding connection is made. This is usually called "visible disconnect".

Separable connectors in MV grids sometimes have to be pulled under load for providing the visible disconnect. This is a cumbersome operation, since the cable has to be handled with sticks to provide the required safety distance to life parts. Commonly, the cable has to be pulled forwardly out of the cable duct in order to park it at a prepared safe place. The general trend of using larger cable cross-sections renders handling the cable including the connector even more difficult.

An easier way of disconnecting a cable is to integrate a removable link element such as a contact pin within the connector and just pull this removable link element with a suitable stick. An example for such an electrical connector assembly is the connector assembly described in US patent US 4,865,559 A.

However, conventional separable MV connectors are covered with an opaque electrically conductive outer screen for technical and for safety reasons. Consequently, a visual check of the status of the removable link element is not possible. From US patent US 8,388,381 B2 an electrical connector assembly is known which has a visible open port provided in a connector body, wherein at least a portion of the insulative material inside the connector body is visible through the visible open port. Providing such an opening within the outer shield, however, has the problem that the electrically conductive layer is interrupted and that safety requirements regarding touch safety can no longer be met.

US 2006/110983 A1 discloses a visible break assembly including a window to view a power connection. According to this document, a device includes a first conductive member configured to be electrically coupled to a first component and a second conductive member configured to be electrically coupled to a second component. The second conductive member is separated from the first conductive member by a gap. A conductive connecting member is moveable to make an electrical connection between the first and second conductive members across the gap. A housing receives the first conductive member, the second conductive member, and the connecting member. The housing includes an insulating layer and a conductive layer. The movement of the connecting member to make the electrical connection is visible through at least a portion of the insulating layer and the conductive layer.

The object underlying the present invention is to overcome the drawbacks of the existing solutions and to provide a protective cover and an electrical connector assembly that allows optical radiation to penetrate the opaque electrically conductive shield, but at the same time does not impair the electrical functionality of the electrically conductive shield. Moreover, there is a need of an electrical connector assembly that provides a visible disconnect without compromising safety or deteriorating the technical functionality of the connector assembly.

This object is solved by the subject matter of the independent claims. Advantageous embodiments of the present invention are the subject matter of the dependent claims.

The present invention is based on the idea that a radiation window that allows optical radiation to penetrate the protective cover can be formed by a plurality of radiation passages. The inventors of the present invention have recognized that by arranging such a plurality of passages adjacently to each other an array of openings is formed that has an electric functionality similar to a mesh or grid forming a Faraday cage: optical radiation is able to permeate the electrically conductive layer, whereas the electric screening effect is not impaired. Consequently, all safety requirements, in particular regarding touch protection, can be fulfilled.

Such an effect could also be achieved by covering a larger window with a transparent, but electrically conductive foil or with an electrically conductive mesh. However, manufacturing such a protective cover and in particular a high-voltage separable connector would be complex and expensive due to the fact that the interface between the separate foil (or mesh) and the connector main body needs to be void free in order to avoid the occurrence of partial discharges. Furthermore, it is important that the foil (or mesh) covering the radiation window is electrically connected to the screen layer. In contrast thereto, the solution according to the present invention has the further advantage that it can be fabricated in a particularly simple and cost-efficient way, and does not need any additional parts. Moreover, the radiation window according to the present invention is formed from the same material as the rest of the protective cover, so that the window also exhibits the same elastic characteristics and identical thermal behavior, leading to a higher robustness and mechanical stability.

According to the present invention, the radiation passages are formed by openings in the electrically conductive layer which are filled with a transparent or translucent material. This ensures that the surface of the protective cover is absolutely smooth with no indentations.

In particular, this transparent or translucent material may be a part of the electrically insulating main body which extends at least through a part of the openings in the electrically conductive layer. Advantageously, for fabricating the structure, the at least partly transparent or translucent main body is provided with a plurality of pillar-shaped protrusions which function as a spacer to create the openings in the opaque electrically conductive layer when fabricating same. Such an array of pillar-shaped protrusions (which may also be called "burls" or "studs") can easily be realized by providing respective openings in a mold that is used for fabricating the electrically insulating main body. For instance, a suitable number of small holes can be drilled into the mold of the insulating main body.

According to the present invention, the electrically insulating body is formed from a transparent or translucent elastomer, e. g. ethylene propylene diene monomer (EPDM) or silicone rubber. The electrically conductive layer is fabricated from a compatible opaque elastomer which is overmolded onto the insulating body.

Consequently, optical radiation can penetrate the radiation window as well as the electrically insulating main body, whereas the electric functionality of the screen layer is not impaired.

As this is generally known, sudden changes in shape of the conductor, for instance corners or edges, lead in high-voltage equipment to a concentration of electric fields at such locations. The concentration of the electric field results in higher electric stress on the dielectric, which may lead to partial discharges and eventually to a degrading of the material. Consequently, according to the present invention, the electrically conductive layer has a chamfered geometry at its interface to the transparent or translucent materials filling the radiation passages, in order to avoid the presence of sharp edges and corners.

The present invention may advantageously be used by providing only one radiation window within the protective cover in order to detect optical radiation that this generated within the protective cover. For instance, the protective cover according to the present invention can be used for covering a connector that comprises an optical communication interface transmitting and/or receiving optical radiation. Such a communication interface is advantageous when the connector additionally comprises sensor equipment, such as temperature monitoring circuitry, and is operable to communicate the information about its status to the outside. Moreover, the optical interface may also be used for transmitting control information from the outside into the connector. Moreover, a single radiation window formed by a plurality of radiation passages can also be used for detecting radiation that is transmitted from the outside through the window and is reflected by a reflective surface, for instance a metallic connector pin, inside the protective cover.

According to an advantageous embodiment of the present invention, the protective cover has a monitoring region with an essentially tubular shape. A first radiation window and a second radiation window, each formed by a plurality of radiation passages, are arranged in the monitoring region to be radially opposing each other with respect to a longitudinal axis of the monitoring region. Such an arrangement allows optical radiation, such as a laser beam, an infrared beam, or a beam of visible light, to enter the protective cover through the first radiation window and to leave the protective cover through the second radiation window, provided that the radiation path is not obstructed. Consequently, the fact whether (or not) optical radiation transmitted into the protective cover is detected at the second radiation window, is indicative of the absence (or presence) of an opaque object in the radiation path. Since there are no transparent electrically conductive materials known so far the identification is inherently safe.

When using the protective cover according to the present invention as a part of an electrical connector, information about the status of the electrical connection, especially about the presence or absence of electrically conductive parts in the radiation path, can be retrieved. A visible disconnect can be thus be provided.

In order to ensure that the electric screening function of the electrically conductive layer is not significantly deteriorated, the geometry of the array of radiation passages has to be optimized. It could be shown that an optimal value for the diameter of the radiation passages lies between 0.5 and 2.5 mm, typically in the range of 1 mm. For safety reasons, the smallest distance between two adjacent radiation passages should be larger than the respective diameter of the radiation passages. In particular, the smallest distance between two adjacent radiation passages is in a range between 0.8 to 4.0 mm. Furthermore, the thickness of the screen layer in relation to the diameter of the radiation passages determines the extent to which the electrical field will penetrate through the non-conductive radiation passage. As a rule of thumb, the thickness of the screen layer should at least be approximately twice the diameter of the radiation passage.

The present invention further relates to a method of fabricating a protective cover according to the present invention. The manufacturing method comprises the following steps:
Forming an electrically insulating at least partly transparent or translucent main body by means of a molding step,
forming an electrically conductive opaque layer on a first surface of the protective cover,
wherein at least one radiation window is formed in the electrically conductive opaque layer by a plurality of radiation passages for allowing optical radiation to penetrate the protective cover.

Advantageously, the radiation window can be fabricated by the same number of molding steps as a protective cover without such a window, thereby avoiding any additional cost intensive fabrication steps. The only modification that has to be made concerns the mold of the electrically insulating main body. This mold can easily be modified by providing a suitable number of small cavities in the mold, for instance by drilling holes into the mold. Additional venting holes can be provided to ensure that the cavities are reliably filled with the elastomeric compound during the molding step. These venting holes may have a diameter that is equal to the diameter of the cavities. In this case small pistons (which are also referred to as stuffer pins) are required to push back the elastomeric compound once the cavities are all filled. Such stuffer pins may advantageously be shaped as defining a desired shape of an end portion of the pillar-shaped protrusions. For instance, the stuffer pins may have a concave shape to define a dome-shaped end portion of the pillar-shaped protrusions.

After the elastomeric molding compound forming the main body has cured completely, a plurality of pillar-shaped protrusions is formed that provide one of the transparent or translucent radiation passages each.

The electrically conductive layer is formed by overmolding the electrically insulating main body. Advantageously, the pillar-shaped protrusions act as spacers because the conductive material essentially is only deposited around the pillar-shaped protrusions, thereby leaving the necessary openings in the opaque material of the electrically conductive layer.

According to an advantageous embodiment of the present invention, the pillar-shaped protrusions are formed to protrude over the electrically conductive opaque layer, wherein the method further comprises the step of shortening the pillar-shaped protrusions to be flush with an outer surface of the electrically conductive opaque layer. By removing an excess length of the pillar-shaped protrusions it can be ensured that no obscuring residues of the opaque material remain that could impair the optical transmittance of the radiation passages.

The present invention further relates to an electrical connector assembly comprising a connector body, at least one first and second conductor receptacle for receiving at least one first and second conductors, respectively, that are to be electrically connected, and at least one first exchangeable electrical link element that is removable from the connector body and formed to establish an electrical connection between said first and second connector. The connector body of the electrical connector assembly is formed as a protective cover according to the principles of the present invention as set forth above.

Such an electrical connector assembly may for instance be a medium voltage separable connector (e. g. a dead break T-connector) that is designed to connect one or more polymeric insulated cables to electric equipment, such as transformers, switchgear, or motors.

According to the present invention, the connector body comprises an electrically insulating at least partly transparent or translucent main body, and an electrically conductive opaque layer, wherein the electrically conductive layer comprises at least one radiation window formed by a plurality of radiation passages for allowing optical radiation to penetrate the connector body.

Advantageously, this arrangement allows verifying the disconnection of the electrical link element between an equipment bushing and a cable by means of optical radiation. Specifically, the present invention can use the fact that an electrically conducting link element blocks the path of a transmitted radiation beam, so that no optical signal is detected in case an electrically conductive link is present. On the other hand, in case of the absence of such an electrically conductive link element, incident radiation may pass through the electrical connector and can be detected by a suitable detecting means or visually by a human operator. As an alternative, also the reflectivity of the link element may be used in order to transmit and receive the radiation through only one radiation window.

According to an advantageous embodiment, the connector body comprises a monitoring region with a tubular shape, wherein a first and a second radiation window are arranged in said monitoring region to be radially opposing each other with respect to a longitudinal axis of the monitoring region. In this manner, radiation can be transmitted into the electrical connector through the first radiation window and can be detected emerging through the second radiation window.

Moreover, for the case where no electrical connection is provided between the first and second conductor, an electrically insulating link element can be provided which is transparent or translucent, so that the optical path of an incident radiation beam is not blocked thereby. In case the insulating link element is inserted, a radiation beam can pass from the first window through the connector body and the inserted insulating link element towards the second window from where it emerges and can be detected. On the other hand, if an electrically conductive link element is inserted, the radiation beam cannot pass. Hence, no radiation is detected at the second radiation window. The emerging radiation may either be detected automatically by a suitable photosensitive element, such as a photodiode, or may be evaluated visually by a human operator.

The radiation window according to the present invention may also be used to establish an optical communication link between electronic circuitry within the electrical connector assembly. This communication link may be only monodirectional, i. e. only from the inside to the outside of the connector or vice versa, but may also be a bidirectional link that allows exchanging information between the electronic circuitry inside the connector and an outside control unit. The electronic circuitry may for instance comprise temperature sensors and suitable signal processing means for generating a warning signal in case the temperature exceeds a defined threshold. This warning signal may be transmitted by means of a light emitting diode (LED) via the optical communication link to the outside control unit.

Furthermore, the present invention relates to a method of monitoring the connected status of an electrical connector assembly, said electrical connector assembly comprising a connector body having an electrically insulating at least partly transparent or translucent main body, and an electrically conductive opaque layer, wherein the electrically conductive layer comprises at least two opposing radiation windows, each formed by a plurality of radiation passages, at least one first and second conductor receptacle for receiving at least one first conductor and at least one second conductor that are to be electrically connected, and at least one first exchangeable electrical link element that is removable from said connector body and is formed to establish an electrical connection between said first and second conductor. The method comprises the following steps:
transmitting optical radiation through said first radiation window to penetrate the connector body only in case said at least one first exchangeable electrical link element is not mounted,
detecting, at the second radiation window, radiation that penetrates the connector body to indicate that said at least one first exchangeable electrical link element is not mounted.

Advantageously, such a monitoring method allows giving a safe feedback on whether the first and second conductors are electrically connected to each other or not. In particular, a positive signal (radiation is detected) signifies the disconnected status. Thereby, an enhanced level of safety is achieved. However, when using only one radiation window, reflected radiation may be used to positively indicate the connected status.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- **FIG. 1**: is a schematic sectional view of a medium voltage separable dead break T-connector connecting a cable to an equipment bushing according to the present invention;
- **FIG. 2**: is a side view of the electrically conductive inner part of the connector shown in Fig. 1 according to a first embodiment;
- **FIG. 3**: is a side view of the electrically conductive inner part of the connector shown in Fig. 1 according to a second embodiment;
- **FIG. 4**: illustrates the functioning of a sealing cap of the connector shown in Fig. 1;
- **FIG. 5**: shows an electrically conductive link element for connecting the cable to the equipment bushing as assembled in Fig. 1;
- **FIG. 6**: shows an electrically conductive link element for providing an earthing for the equipment bushing;
- **FIG. 7**: shows an electrically conductive link element for providing an earthing for the cable;
- **FIG. 8**: shows an electrically conductive link element for providing an earthing for both the cable and the equipment bushing;
- **FIG. 9**: shows an electrically insulating link element;
- **FIG. 10**: shows a schematic sectional view of an arrangement for detecting a disconnected state of the T-connector as shown in Fig. 1;
- **FIG. 11**: shows the arrangement of Fig. 10 rotated by 90°;
- **FIG. 12**: shows a schematic perspective view of a part of a protective cover having a radiation window formed by a plurality of radiation passages;
- **FIG. 13**: shows a perspective sectional view of the arrangement of Fig. 12;
- **FIG. 14**: shows a perspective sectional view of a main body according to a first embodiment before overmolding with the electrically conductive layer;
- **FIG. 15**: shows a perspective sectional view of a main body according to a second embodiment after overmolding with an electrically conductive layer;
- **FIG. 16**: shows a perspective sectional view of the main body as shown in Fig. 15 after removing excess insulating material;
- **FIG. 17**: shows a schematic perspective sectional view of a part of a mold for fabricating the transparent or translucent main body;
- **FIG. 18**: illustrates the shape of the cavities formed in the mold of Fig. 17.

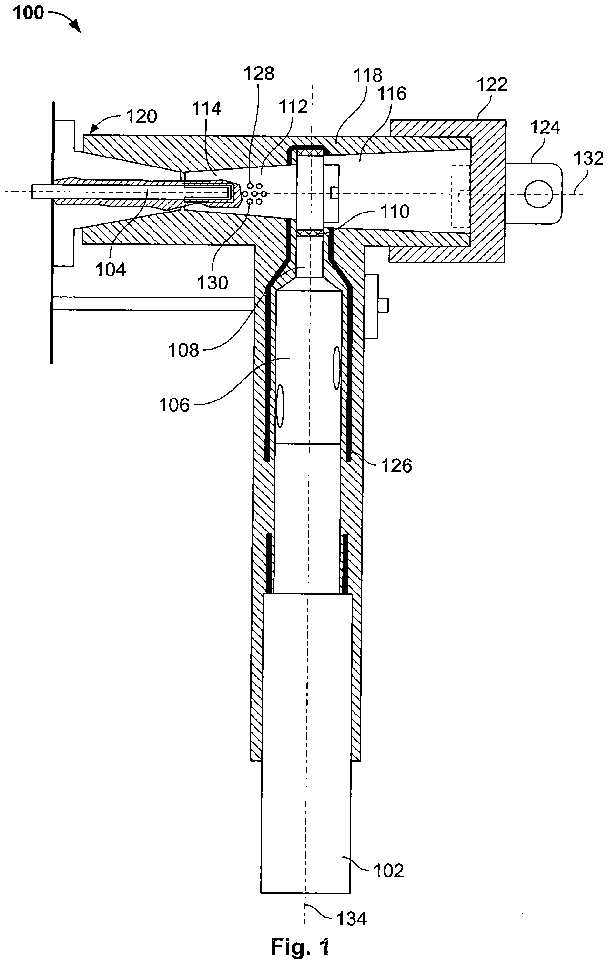

The present invention will now be explained in more detail with reference to the Figures and firstly referring to Fig. 1. Figure 1 shows a schematic sectional view of a disconnectable medium voltage (MV) dead break T-connector as an example of an electrical connector assembly 100 that can benefit from the ideas according to the present invention.

As shown exemplarily in Fig. 1, the electrical connector assembly 100 establishes an electrical connection between a cable 102 and an equipment bushing 104, for instance for connecting a transformer. The conductive core of a cable 102 is introduced into a connector 106 which forms a first conductor receptacle. The connector 100 comprises a ring shaped contact element 108 which can electrically contact a link element via a spring contact 110. The link element 112 according to the present invention is a removable part and may be exchanged according to the desired functionality. In the arrangement shown in Fig. 1, the link element 112 comprises an electrically conductive bridge 114 which establishes an electrical contact between the first connector receptacle 106 and the equipment bushing 104. Furthermore, the link element 112 comprises a first insulating plug 116 for covering the conductive bridge 114.

The connector assembly 100 comprises a connector main body 118 which serves as a protective cover for the T-connector. The outer surface of the main body 118 is covered with an electrically conductive layer 120. According to the present invention, the bulk material of the main body 118 is a transparent or translucent electrically insulating elastomer, whereas the electrically conductive outer layer 120 is opaque. A sealing end cap 122 is provided for closing the connector assembly. The end cap 122 has a connecting lug 124 for attaching an earthing cable (not shown in the Figures). Moreover, field control and faraday cage elements 126 are provided as this is known in the art.

According to the present invention, the main body 118 comprises two opposing radiation windows 128 in a monitoring region as schematically shown in Fig. 1. Each of the radiation windows 128 is formed by a plurality of radiation passages 130. In an exemplary embodiment, a rotationally symmetric array of seven radiation passages 130 may form the radiation window 128. However, any other number and arrangement of radiation passages 130 is also possible.

As can be seen from Fig. 1, the electrically conductive bridge 114 is opaque and therefore blocks a radiation path (extending across a longitudinal axis 132 and perpendicular to the drawing plane of Figure 1) between two opposing radiation windows 128. Consequently, radiation that is emitted into a first of the radiation windows 128 cannot reach the second radiation window and will therefore not be detected. Consequently, the situation of an established electrical connection between the cable 102 and the equipment bushing 104 is indicated by the absence of detected radiation. On the other hand, if the conductive bridge 114 is not present, or is replaced by an electrically insulating part which is transparent or translucent, transmitted radiation may penetrate the electrical connector assembly from one radiation window to the opposing radiation window and can be detected by suitable detecting means or visually by a human operator. In other words, the presence of detectable radiation indicates the absence of the electrically conductive bridge 114. Therefore, this construction fulfills the requirement of a visible disconnect.

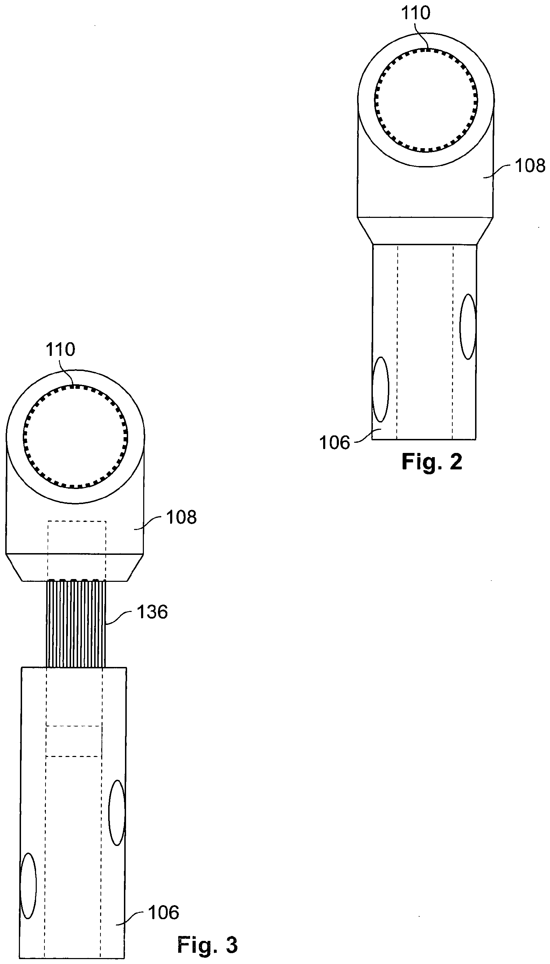

Figures 2 and 3 show the first connector receptacle 106 with its ring shaped contact element 108 rotated by 90° around the cable axis 134. A spring contact 110 establishes the connection to the electrically conductive bridge 114. According to a first embodiment (Fig. 2), the ring shaped contact element 108 is connected to the first conductor receptacle 106 in a rigid manner. Alternatively, a semi-flexible connection 136 may be provided as shown in Fig. 3.

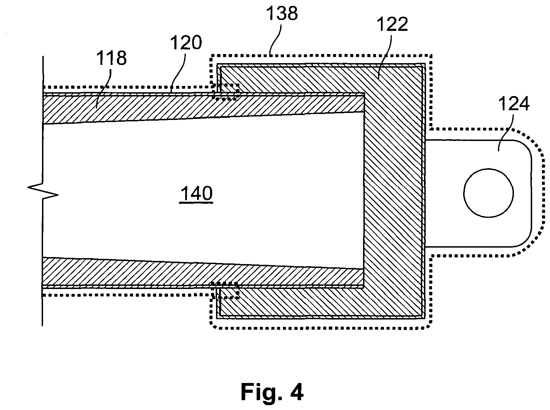

Fig. 4 illustrates the function of the sealing end cap 122 of Fig. 1. According to the present invention, the end cap 122 and the main body 118 are both fabricated from an electrically insulating material and are both covered by an electrically conductive outer layer 120 (not to scale in its thickness). It could be shown that by providing a tight press-fit with a sufficiently large overlap between the main body 118 and the end cap 122, an outer earth current path 138 will not reach into an inner region 140 of the main body 118. Instead, the earth current path 138 safely reaches the earthing lug 124. Usually, a further earthing connection (not shown in the Figures) is provided at the main body 118.

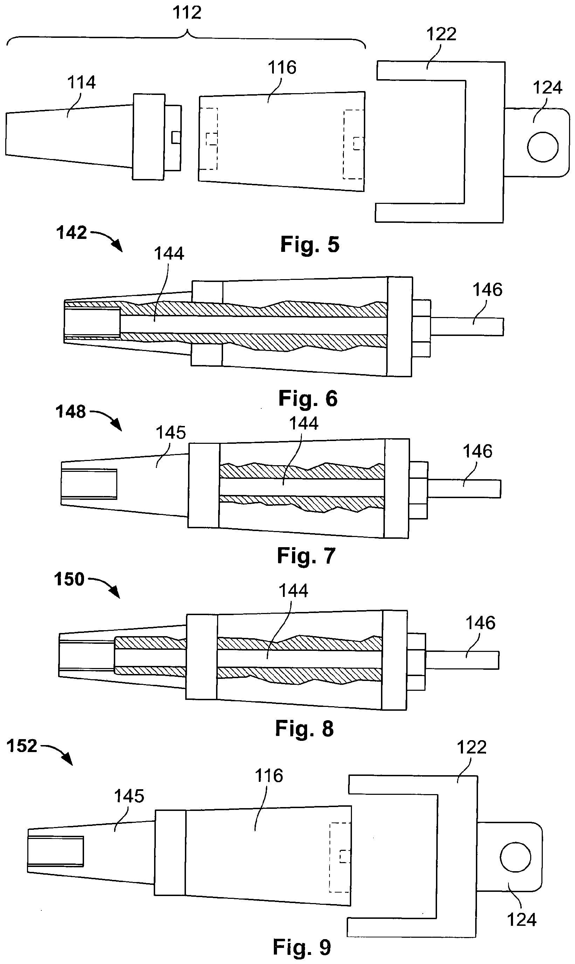

Figures 5 to 9 illustrate different exchangeable link elements 112 can be used in the dead break T-connector 100 shown in Fig. 1. In Fig. 5 a first link element 112 comprising an electrically conductive, for instance metallic, bridge 114 and a first insulating plug 116 is shown. As already mentioned with reference to Fig. 1, an end cap 122 has to be used together with this first link element 112 in order to seal the connector assembly. When the first link element 112 according to Fig. 5 is mounted, an electrical connection is established between the cable 102 and the equipment bushing 104.

Fig. 6 shows in a schematic partially opened view a second link element 142. The second link element provides an electric connection 144 from the equipment bushing to a fixed earthing connector 146. By screwing in the second link element 142 instead of the first link element 112, the equipment bushing 104 can be connected to earth. The end cap 122 is not used with the link elements shown in Figures 6 to 8, and the earthing of the main body's outer surface is only provided by the above mentioned further earthing connection at the main body.

As an alternative, a third link element 148 may be provided that is formed to connect the cable via an electric connection 144 to an earthing connector 146. A second electrically insulating and transparent (or translucent) plug 145 is provided at the interface to the equipment bushing 104. This arrangement is shown in Fig. 7. A further electrically conductive link element 150 is shown in Fig. 8. Here, the electrical connection 144 connects the equipment bushing 104 as well as the cable 102 with the earthing connector 146.

In contrast to the electrically conductive link elements 112, 142, 148, 150 shown in Figures 5 to 8, Figure 9 shows a completely insulating link element 152. Essentially, the link element 152 is a combination of the first and second insulating plugs 116, 145. At least the second insulating plug 145 is formed from a transparent or translucent material, preferably an elastomer like the one forming the main body 118.

When additionally referring back to Fig. 1, it can be seen that an unobstructed radiation path for radiation incident through a radiation window 128 is only provided in the case where the link elements 148 and 152 are mounted which have a transparent or translucent insulating second plug 145. These are also the situations, where no electrical connection exists between the equipment bushing 104 and the cable 102, in other words, the safely disconnected states.

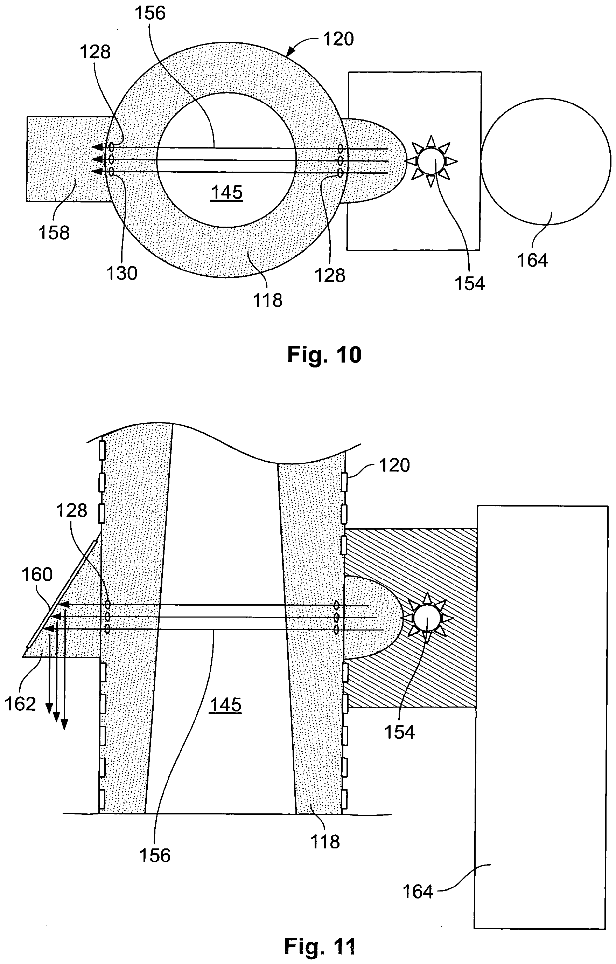

Fig. 10 and 11 illustrate a possible setup for determining the safe disconnect of the electrical connector assembly 100 according to the present invention. As already mentioned above, the actual measurement is performed in the monitoring region of the connector assembly 100 shown in Fig. 1, where-depending on the connection state of the connector assembly-either a radiation path obstructing electrically conductive part or a translucent (or transparent) insulating plug is mounted. The connector main body 118 is fabricated from a transparent or translucent material and on its outside is covered by an opaque electrically conductive layer 120. According to the present invention two radiation windows 128 each formed by a plurality of radiation passages 130 are formed within the electrically conductive opaque layer 120. Again, it has to be stressed that the drawing is not to scale.

When it has to be determined whether an electrically insulating plug 145 is inserted and whether therefore the connector assembly is in a safely disconnected state, a radiation source 154 is brought into close proximity of a first of the radiation windows 128 to transmit radiation into the main body 118. The radiation source 154 may for instance be formed by one or more light emitting diodes (LED), a laser, or an incandescent light source. Suitable radiation shaping means, such as lenses, mirrors, or the like may of course additionally be provided.

The radiation beam 156 passes through the radiation passages 130 within the opaque outer insulation layer 120, penetrates the translucent or transparent material of the main body 118, and passes through the electrically insulating second plug 145. At the opposing side of the main body 118 a second radiation window 128 is provided through which the radiation beam 156 may exit. At the second radiation window 128, detection means 158 are provided for detecting the presence of an emerging radiation beam 156. Suitable detection means 158 may for instance comprise a photodiode or a CCD (charge-coupled device) unit. Alternatively, it may also be sufficient that a human operator directly and visually controls the radiation window 128.

Fig. 11 shows an advantageous embodiment wherein a mirror 160 is attached to the second radiation window 128 for deflecting the radiation beam 156. In this manner an operator can more easily control whether a light beam is visible through the second radiation window 128 or not. The mirror 160 may be attached to the outside of the connector 100 by means of a transparent light guiding structure 162. The light guiding structure 162 and the mirror may be an integral part of the main body 118 and may be attached to its surface by means of any suitable techniques, such as gluing or welding.

In order to meet the respective safety regulations for high-voltage equipment, the radiation source 154 may be mounted on a suitable stick 164. However, a light source 154 may also be permanently attached to the outer surface of the main body 118.

An important aspect of the present invention is the idea to form the radiation window 128 from a plurality of radiation passages 130 in order to meet the safety requirements for high-voltage equipment. This particular idea is advantageous when being applied to an electrical connector assembly as explained with reference to Figures 1 to 11. However, the principle of piecing together a plurality of radiation passages to form a radiation window can be applied to any sort of protective cover comprising a transparent (or translucent) insulating body and an opaque electrically conductive layer.

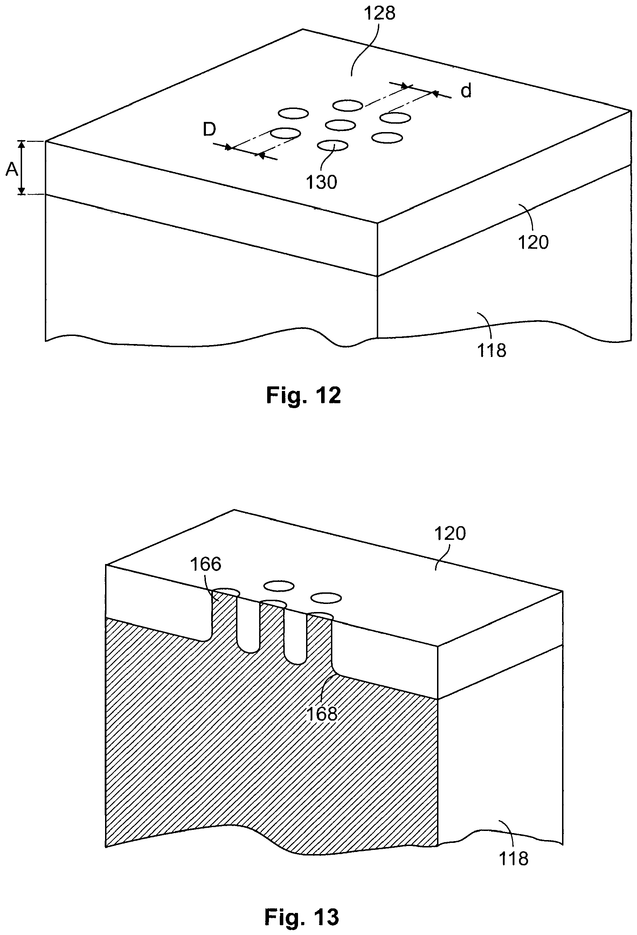

Fig. 12 shows in an enlarged perspective view a small section of the main body 118 and the electrically conductive opaque layer 120 functioning as a screen. A radiation window 128 is formed in the opaque layer 120 by an array of seven radiation passages 130. Each of the passages 130 is formed by an opening in the electrically conductive opaque layer 120 which is filled by a transparent or translucent material. The diameter D of the radiation passages 130 lies in the range of between 0.5 to 2.5 mm. This value essentially depends on the electrical fields that have to be handled and on the thickness A of the electrically conductive layer 120. It is essential that the electrical field cannot reach outside through the radiation passages 130. For higher values of the thickness A also larger diameters D are admissible.

Furthermore, the distance d between two adjacent radiation windows 128 should be larger than the respective diameter in order to ensure that the electrically conductive layer D provides a sufficient covering and electrical conductivity along the screen layer 120. For instance, values from 0.8 mm to 4.0 mm are advantageously chosen.

Of course, as a person skilled in the art is aware, any other number of radiation passages 130 in a different arrangement as the one exemplarily shown in the Figures is also encompassed by the present invention, provided the diameters and distances are chosen to ensure the required touch protection. Moreover, the radiation passages 130 may of course also have any other than a circular cross-section, for instance a rectangular, polygonal, oval, or triangular cross-section can also be provided.

In order to further illustrate the shape of the radiation passages 130, in Fig. 13 a schematic cut through the window 128 of Fig. 12 is shown. According to the present invention, the electrically insulating transparent (or translucent) material that fills the radiation passages 130 is formed by pillar-shaped protrusions 166 (which also may be referred to as "burls") fabricated from the same material as the main body 118. These pillar-shaped protrusions 166 on the one hand provide an electrically insulating and optically conductive filling for the radiation passages 130. On the other hand, the protrusions 166 act as spacers and define the openings in the opaque layer 120 when the opaque layer is fabricated by overmolding the main body 118 with the protrusions 166 provided thereon.

Advantageously, each of the pillar-shaped protrusions 166 has a rounded base 168 at the transition to the bulk material of the main body 118 in order to avoid sharp edges at the interface between the electrically conductive layer 120 and the electrically insulating main body 118. Such a field control is advantageous for avoiding partial discharges at this interface.

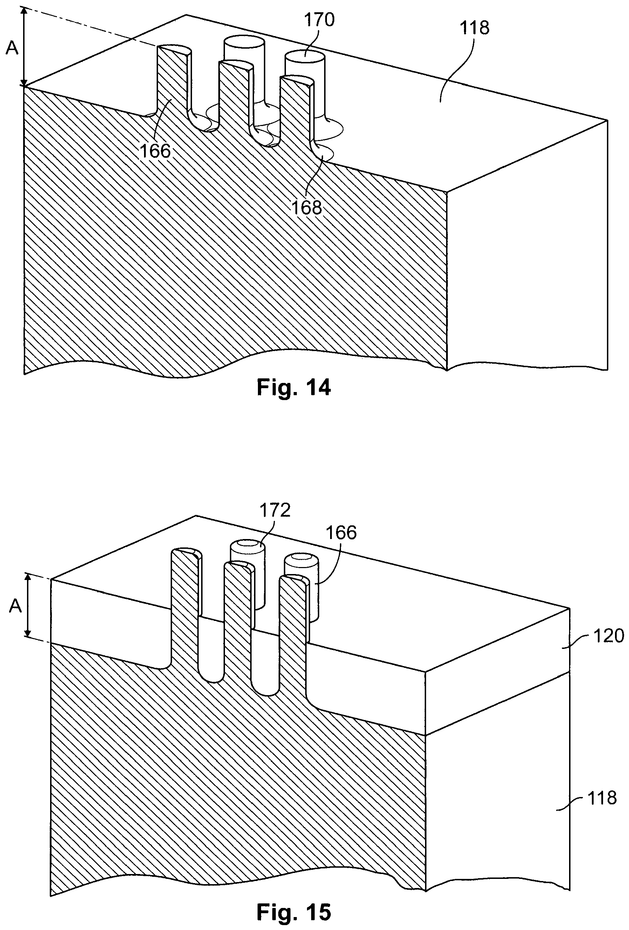

Figure 14 shows the main body 118 according to a first embodiment after the mold has been removed and before the electrically conductive opaque layer 120 is added. According to this embodiment, the pillar-shaped protrusions 166 are formed to have the same height A as the electrically conductive opaque layer 120. However, problems may occur due to a contamination of the upper surfaces 170 of the pillar-shaped protrusions 166 by undesired residues of the opaque material because the surfaces 170 are the optically active surfaces of the radiation window 128 and will be obscured by any opaque deposits.

Consequently, according to an improved embodiment which is shown in Fig. 15, the pillar-shaped protrusions 166 are formed to be longer than the final length A. Moreover, the distal ends of the pillar-shaped protrusions 166 are provided with a convex surface 172. Such a convex surface 172 facilitates removing the mold without damaging the mechanically fragile structures of the pillar-shaped protrusions 166 and, furthermore, reduces the amount of opaque material that is deposited on top of the pillar-shaped protrusions 166 when applying the electrically conductive layer 120.

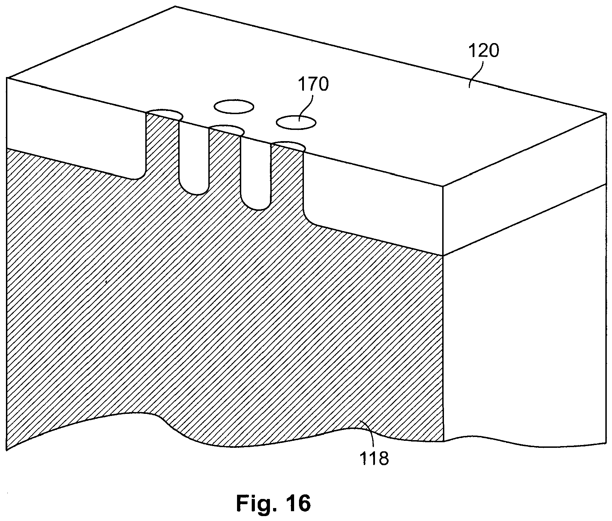

According to this embodiment, the excess length of the pillar-shaped protrusions 166 which is protruding from the surface of the fully annealed electrically insulating layer 120 is removed by a mechanical abrasion step, resulting in completely clean active surfaces 170 as shown in Fig. 16.

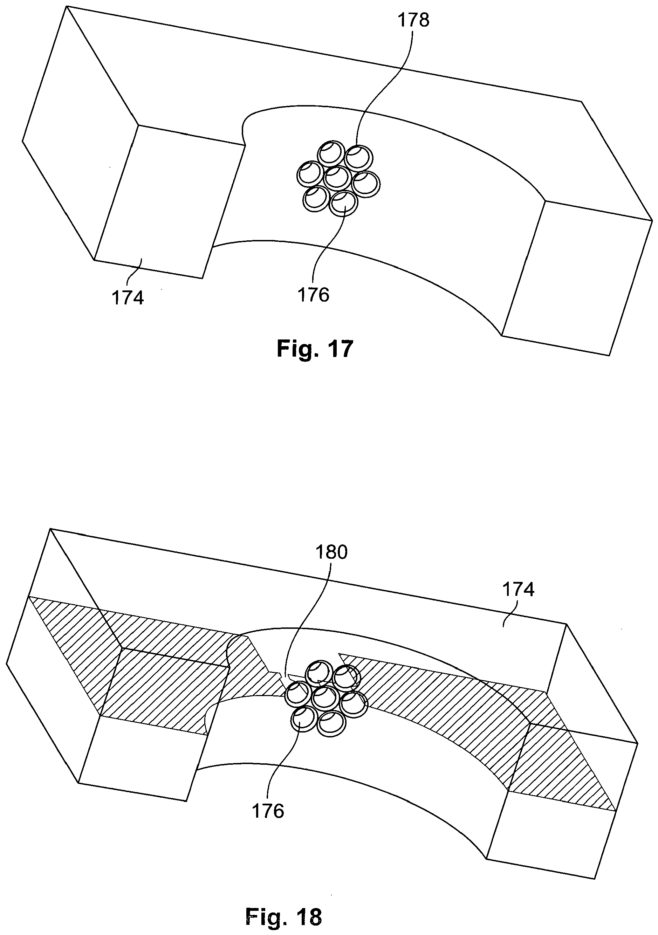

For fabricating the electrically insulating main body, a mold 174 has to be provided with respective cavities 176. Fig. 17 shows in a schematic perspective view of the part of the mold 174 which is formed to structure the pillar-shaped protrusions 166. Depending on whether a corresponding radiation window 128 is provided at the opposing side of the protective cover, the belonging second half of the mold 174 either has a similar array of cavities 176 or not.

The cavities 176 may simply be formed as cylindrical bores. Pistons (also referred to as "stuffer pins") which are not shown in the Figures may be inserted from the outside of the mold 174 in order to push back the mold compound once the cavities 176 are filled. By correspondingly shaping the pistons, a particular form of the end region of the pillar-shaped protrusions 166 can be achieved. For instance, a concave piston produces a convex shape of the upper end of the pillar-shaped protrusions 166.

Advantageously, the mold has rounded or chamfered shoulders 178 at the end regions of the cavities 176 in order to form the above-mentioned rounded bases 168 of the pillar-shaped protrusions 166. These chamfered shoulders 178 are essentially mirrored by the shape of the electrically conductive opaque layer 120.

Fig. 18 illustrates by means of a schematic intersecting plane a second advantageous embodiment of the mold's cavities 176. According to this embodiment, venting apertures 118 are provided at the end of the cavities 176 that forms the upper end of the pillar-shaped protrusions 166. Such venting holes facilitate a bubble free filling of the cavities 176. Advantageously, the resulting pillar-shaped protrusions 166 are again slightly longer than the later thickness A of the electrically conductive opaque layer 120, so that the final optically active surfaces 170 can be made plane and free of burr by an additional machining process.

With reference to all of Fig. 12 to 18, the individual method steps for fabricating a protective cover, for instance for use in an electrical connector assembly, will be explained in the following.

Firstly, a mold 174 which is pieced together from at least two separable parts is filled with a liquid precursor of a transparent (or translucent) electrically insulating material for forming an electrically insulating main body 118. This may for instance be a transparent (or translucent) elastomer (e. g. EPDM or silicone rubber). An array of cavities 176, which are provided in at least one region of the mold 176, are filled with the insulating material to form pillar-shaped protrusions 166 which at least have a length corresponding to the later thickness A of the electrically conductive opaque layer 120.

After the electrically insulating compound has cured completely, the mold 174 is removed.

In the next step, the electrically insulating main body 118 comprising the pillar-shaped protrusions 166 is overmolded with a further elastomeric compound, which is electrically conductive and opaque, in order to form the electrically conductive opaque layer 120. The pillar-shaped protrusions 166 thus form spacers that define the insulator filled openings constituting the radiation passages 130 according to the present invention.

After the electrically conductive opaque layer 120 is fully cured, an optional machining step can be performed for removing any undesired excess material at the pillar-shaped protrusions 166. Thereby, smooth and clean optically active surfaces 170 can be provided.

**REFERENCE NUMERALS**

| **Reference Numeral** | **Description** |
|---|---|
| 100 | Electrical connector assembly |
| 102 | High-voltage cable |
| 104 | Equipment bushing |
| 106 | First conductor receptacle |
| 108 | Ring-shaped contact element |
| 110 | Spring contact |
| 112 | First link element |
| 114 | Electrically conductive bridge |
| 116 | First insulating plug |
| 118 | Electrically insulating main body |
| 120 | Electrically conductive opaque layer |
| 122 | Sealing end cap |
| 124 | Connecting lug for earthing |
| 126 | Field control and faraday cage elements |
| 128 | Radiation window |
| 130 | Radiation passage |
| 132 | Longitudinal axis |
| 134 | Cable axis |
| 136 | Semi-flexible connection |
| 138 | Earth current path |
| 140 | Inner region |
| 142 | Second link element |
| 144 | Electric connection |
| 145 | Second insulating plug |
| 146 | Earthing connector |
| 148 | Third link element |
| 150 | Electrically insulating fourth link element |
| 152 | Fifth link element |
| 154 | Radiation source |
| 156 | Radiation beam |
| 158 | Detection means |
| 160 | Mirror |
| 162 | Radiation guiding structure |
| 164 | Stick |
| 166 | Pillar-shaped protrusion |
| 168 | Base of protrusion |
| 170 | Upper surface of protrusion, optically active surface |
| 172 | Convex surface of protrusion |
| 174 | Mold |
| 176 | Cavity |
| 178 | Shoulder at cavity |
| 180 | Venting aperture |

## Claims

1. Protective cover for medium or high-voltage connector, the cover comprising:
an electrically insulating at least partly transparent or translucent main body (118),
an electrically conductive opaque layer (120), wherein the electrically conductive layer (120) comprises at least one radiation window (128) that allows optical radiation to penetrate the protective cover,
**characterized in that**
the radiation window is formed by a plurality of radiation passages, wherein the radiation passages (130) form an array that forms an electrically screening Faraday cage.

2. Protective cover according to claim 1, wherein said radiation passages (130) are formed by openings in the electrically conductive layer (120) which are filled with a transparent or translucent material.

3. Protective cover according to claim 2, wherein said transparent or translucent material is a part of the main body (118) extending through at least a part of said openings.

4. Protective cover according to claim 3, wherein said electrically conductive layer (120) has a chamfered region (178) at an interface to the transparent or translucent material.

5. Protective cover according to one of the preceding claims, said protective cover having a monitoring region with a tubular shape, wherein a first and a second radiation window (128) are arranged in said monitoring region to be radially opposing each other with respect to a longitudinal axis (132) of the monitoring region.

6. Protective cover according to one of the preceding claims, wherein said radiation passages (130) have a diameter D in a range between 0.5 to 2.5 mm, and wherein the smallest distance d between two adjacent radiation passages is larger than the respective diameter D of said radiation passages, and/or wherein the smallest distance d between two adjacent radiation passages (130) is in a range between 0.8 to 4.0 mm.

7. Method of fabricating a protective cover according to one of the preceding claims, said method comprising the following steps:
forming an electrically insulating at least partly transparent or translucent main body (118) by means of a molding step,
forming an electrically conductive opaque layer (120) on a first surface of the protective cover,
wherein at least one radiation window (128) is formed in the electrically conductive opaque (120) layer by a plurality of radiation passages (130), wherein the radiation passages (130) form an array that allows optical radiation to penetrate the protective cover and forms an electrically screening Faraday cage.

8. Method according to claim 7, wherein the radiation passages (130) are fabricated when molding the main body (118) by forming a plurality of pillar-shaped protrusions (166) in cavities (176) of a mold (174), and by subsequently overmolding the main body (118) with an electrically conductive opaque material.

9. Method according to claim 8, wherein the step of forming the pillar-shaped protrusions (166) further comprises forming a dome shaped end portion (172) on each of the pillar-shaped protrusions (166).

10. Method according to claim 8 or 9, wherein the pillar-shaped protrusions (166) are formed in their longitudinal height and in the structure of their end portion by a plurality of pistons that are inserted each into one of the cavities (176) of the mold (174).

11. Method according to one of the claims 7 to 10, wherein the pillar-shaped protrusions (166) are formed to protrude above the electrically conductive opaque layer (120), and wherein the method further comprises the step of shortening the pillar-shaped protrusions (166) to be flush with an outer surface of the electrically conductive opaque layer (120).

12. Electrical connector assembly for medium or high-voltage comprising:
a connector body,
at least one first and second conductor receptacle for receiving at least one first conductor (102) and at least one second conductor (104) that are to be electrically connected, and
at least one first exchangeable electrical link element (112, 142, 150) that is removable from said connector body and is formed to establish an electrical connection between said first and second conductor (102, 104),
wherein said connector body comprises a protective cover according to one of the claims 1 to 6.

13. Electrical connector assembly according to claim 12, wherein said connector body comprises a monitoring region with a tubular shape, wherein a first and a second radiation window (128) are arranged in said monitoring region to be radially opposing each other with respect to a longitudinal axis (132) of the monitoring region.

14. Electrical connector assembly according to claim 12 or 13, further comprising a second exchangeable electrical link element (152) that provides electrical insulation between said first and second conductor (102, 104), and/or further comprising a third exchangeable electrical link element (148) that provides an electrical insulation between said first and second conductor, and an electrical connection between said first conductor and ground potential.

15. Method of monitoring the connected status of an electrical connector assembly according to claim 12, said method comprises the following steps:
transmitting optical radiation (156) through said first radiation window (128) to penetrate the connector body only in case said at least one first exchangeable electrical link (112, 142, 144) element is not mounted,
detecting, at the second radiation window (128), radiation that penetrated the connector body to indicate that said at least one first exchangeable electrical link element is not mounted.

## Patentansprüche

1. Schutzabdeckung für einen Mittel- oder Hochspannungs-Verbinder, wobei die Abdeckung umfasst:
einen elektrisch isolierenden, wenigstens teilweise transparenten oder transluzenten Hauptkörper (118),
eine elektrisch leitende undurchsichtige Schicht (120), wobei die elektrisch leitende Schicht (120) wenigstens ein Strahlungs-Fenster (128) umfasst, das zulässt, dass optische Strahlung durch die Schutzabdeckung hindurch gelangt,
**dadurch gekennzeichnet, dass**
das Strahlungs-Fenster durch eine Vielzahl von Strahlungs-Durchlassen (130) gebildet wird, wobei die Strahlungs-Durchlasse (130) eine Anordnung bilden, die einen elektrisch abschirmenden Faraday-Käfig bildet.

2. Schutzabdeckung nach Anspruch 1, wobei die Strahlungs-Durchlasse (130) durch Öffnungen in der elektrisch leitenden Schicht (120) gebildet werden, die mit einem transparenten oder transluzenten Material gefüllt sind.

3. Schutzabdeckung nach Anspruch 2, wobei das transparente oder transluzente Material ein Teil des Hauptkörpers (118) ist, der sich durch wenigstens einen Teil der Öffnungen hindurch erstreckt.

4. Schutzabdeckung nach Anspruch 3, wobei die elektrisch leitende Schicht (120) einen abgeschrägten Bereich (178) an einer Grenzfläche zu dem transparenten oder transluzenten Material hat.

5. Schutzabdeckung nach einem der vorangehenden Ansprüche, wobei die Schutzabdeckung einen Überwachungs-Bereich mit einer Röhrenform hat, ein erstes und ein zweites Strahlungs-Fenster (128) in dem Überwachungs-Bereich so angeordnet sind, dass sie einander in Bezug auf eine Längsachse (132) des Überwachungs-Bereiches radial gegenüberliegen.

6. Schutzabdeckung nach einem der vorangehenden Ansprüche, wobei die Strahlungs-Durchlasse (130) einen Durchmesser D in einem Bereich zwischen 0,5 und 2,5 mm haben und der kleinste Abstand d zwischen zwei benachbarten Strahlungs-Durchlassen größer ist als der jeweilige Durchmesser D der Strahlungs-Durchlasse und/oder der kleinste Abstand d zwischen zwei benachbarten Strahlungs-Durchlassen (130) in einem Bereich zwischen 0,8 und 4,0 mm liegt.

7. Verfahren zum Herstellen einer Schutzabdeckung nach einem der vorangehenden Ansprüche, wobei das Verfahren die folgenden Schritte umfasst:
Ausbilden eines elektrisch isolierenden, wenigstens teilweise transparenten oder transluzenten Hauptkörpers (118) mittels eines Form-Schrittes,
Ausbilden einer elektrisch leitenden undurchsichtigen Schicht (120) an einer ersten Fläche der Schutzabdeckung,
wobei wenigstens ein Strahlungs-Fenster (128) in der elektrisch leitenden undurchsichtigen Schicht (120) durch eine Vielzahl von Strahlungs-Durchlassen (130) gebildet wird, wobei die Strahlungs-Durchlasse (130) eine Anordnung bilden, die zulässt, dass optische Strahlung durch die Schutzabdeckung hindurch gelangt, und die einen elektrisch abschirmenden Faraday-Käfig bildet.

8. Verfahren nach Anspruch 7, wobei die Strahlungs-Durchlasse (130) hergestellt werden, wenn der Hauptkörper (118) geformt wird, indem eine Vielzahl säulenförmiger Vorsprünge (166) in Hohlräumen (176) einer Form (174) ausgebildet werden und anschließend ein elektrisch leitendes undurchsichtiges Material auf den Hauptkörper (118) aufgeformt wird.

9. Verfahren nach Anspruch 8, wobei der Schritt des Ausbildens der säulenförmigen Vorsprünge (166) des Weiteren Ausbilden eines kuppelförmigen Endabschnitts (172) an jedem der säulenförmigen Vorsprünge (166) umfasst.

10. Verfahren nach Anspruch 8 oder 9, wobei die säulenförmigen Vorsprünge (166) in ihrer Höhe in Längsrichtung und hinsichtlich des Aufbaus ihres Endabschnitts mittels einer Vielzahl von Kolben ausgebildet werden, die jeweils in einen der Hohlräume (176) der Form (174) eingeführt werden.

11. Verfahren nach einem der Ansprüche 7 bis 10, wobei die säulenförmigen Vorsprünge (166) so ausgebildet werden, dass sie oberhalb der elektrisch leitenden undurchsichtigen Schicht (120) vorstehen, und wobei das Verfahren des Weiteren den Schritt umfasst, in dem die säulenförmigen Vorsprünge (166) so gekürzt werden, dass sie bündig mit einer Außenfläche der elektrisch leitenden undurchsichtigen Schicht (120) sind.

12. Elektrische Verbinder-Anordnung für Mittel- oder Hochspannung, die umfasst:
einen Verbinder-Körper,
wenigstens eine erste und eine zweite Leiter-Buchse zum Aufnehmen wenigstens eines ersten Leiters (102) und wenigstens eines zweiten Leiters (104), die elektrisch verbunden werden, sowie
wenigstens ein erstes austauschbares elektrisches Verbindungs-Element (112, 142, 150), das von dem Verbinder-Körper abgenommen werden kann und so ausgebildet ist, dass es eine elektrische Verbindung zwischen dem ersten und dem zweiten Leiter (102, 104) herstellt,
wobei der Verbinder-Körper eine Schutzabdeckung nach einem der Ansprüche 1 bis 6 umfasst.

13. Elektrische Verbinder-Anordnung nach Anspruch 12, wobei der Verbinder-Körper einen Überwachungs-Bereich mit einer Röhrenform umfasst, und ein erstes sowie ein zweites Strahlungs-Fenster (128) in dem Überwachungs-Bereich so angeordnet sind, dass sie einander in Bezug auf eine Längsachse (132) des Überwachungs-Bereiches radial gegenüberliegen.

14. Elektrische Verbinder-Anordnung nach Anspruch 12 oder 13, die des Weiteren ein zweites austauschbares elektrisches Verbindungs-Element (152) umfasst, das elektrische Isolierung zwischen dem ersten und dem zweiten Leiter (102, 104) herstellt, und/oder die des Weiteren ein drittes austauschbares elektrisches Verbindungs-Element (148) umfasst, das eine elektrische Isolierung zwischen dem ersten und dem zweiten Leiter sowie eine elektrische Verbindung zwischen dem ersten Leiter und Erdpotential herstellt.

15. Verfahren zum Überwachen des Verbindungs-Status einer elektrischen Verbinder-Anordnung nach Anspruch 12, wobei das Verfahren die folgenden Schritte umfasst:
Durchlassen optischer Strahlung (156) durch das erste Strahlungs-Fenster (128), so dass sie nur in einem Fall durch den Verbinder-Körper hindurch gelangt, in dem das wenigstens eine erste austauschbare elektrische Verbindungs-Element (112, 142, 144) nicht angebracht ist,
Erfassen von Strahlung, die durch den Verbinder-Körper hindurch gelangt ist und anzeigt, dass das wenigstens eine erste austauschbare elektrische Verbindungs-Element nicht angebracht ist, an dem zweiten Strahlungs-Fenster (128).

## Revendications

1. Couvercle de protection pour connecteur moyenne ou haute tension, le couvercle comprenant:
un corps principal (118) électriquement isolant au moins en partie transparent ou translucide,
une couche opaque électriquement conductrice (120), dans laquelle la couche électriquement conductrice (120) comprend au moins une fenêtre de rayonnement (128) permettant à un rayonnement optique de pénétrer dans le couvercle de protection, **caractérisé en ce que**
la fenêtre de rayonnement est constitué d'une pluralité de passages de rayonnement, les passages de rayonnement (130) constituant un réseau formant une cage de Faraday à blindage électrique.

2. Couvercle de protection selon la revendication 1, dans laquelle lesdits passages de rayonnement (130) sont constitués d'ouvertures dans la couche électriquement conductrice (120) qui sont remplies d'un matériau transparent ou translucide.

3. Couvercle de protection selon la revendication 2, dans laquelle ledit matériau transparent ou translucide est une partie du corps principal (118) s'étendant à travers au moins une partie desdites ouvertures.

4. Couvercle de protection selon la revendication 3, dans laquelle ladite couche électriquement conductrice (120) possède une zone chanfreinée (178) au niveau d'une interface avec le matériau transparent ou translucide.

5. Couvercle de protection selon l'une des revendications précédentes, ledit couvercle de protection possédant une zone de surveillance de forme tubulaire, dans lequel une première et une seconde fenêtre de rayonnement (128) sont disposées dans ladite zone de surveillance pour s'opposer radialement l'une à l'autre par rapport à un axe longitudinal (132) de la zone de surveillance.

6. Couvercle de protection selon l'une des revendications précédentes, dans laquelle lesdits passages de rayonnement (130) ont un diamètre D compris entre 0,5 et 2,5 mm et dans lequel la plus petite distance d entre deux passages de rayonnement adjacents est supérieure au diamètre respectif D desdits passages de rayonnement, et/ou dans lequel la plus petite distance d entre deux passages de rayonnement adjacents (130) se situe dans une plage comprise entre 0,8 et 4,0 mm.

7. Procédé de fabrication d'un couvercle de protection selon l'une des revendications précédentes, ledit procédé comprenant les étapes suivantes:
former un corps principal (118) électriquement isolant au moins en partie transparent ou translucide à l'aide d'une étape de moulage,
former une couche opaque électriquement conductrice (120) sur une première surface du couvercle de protection,
dans lequel au moins une fenêtre de rayonnement (128) est formée dans la couche opaque électriquement conductrice (120) par une pluralité de passages de rayonnement (130), les passages de rayonnement (130) formant un réseau qui permet au rayonnement optique de pénétrer dans le couvercle de protection et forme une cage de Faraday électriquement blindée.

8. Procédé selon la revendication 7, dans lequel les passages de rayonnement (130) sont fabriqués lors du moulage du corps principal (118) en formant une pluralité de saillies en forme de piliers (166) dans des cavités (176) d'un moule (174) et en surmoulant ensuite le corps principal (118) avec un matériau opaque électriquement conducteur.

9. Procédé selon la revendication 8, dans lequel l'étape consistant à former les saillies en forme de pilier (166) comprend en outre la formation d'une partie d'extrémité en forme de dôme (172) sur chacune des saillies en forme de pilier (166).

10. Procédé selon les revendications 8 ou 9, dans lequel les saillies en forme de pilier (166) sont formées leur hauteur longitudinale et dans la structure de leur portion extrême par une pluralité de pistons qui sont insérés chacun dans l'une des cavités (176) du moule (174).

11. Procédé selon l'une des revendications 7 à 10, dans lequel les saillies en forme de pilier (166) sont formés pour faire saillie au-dessus de la couche opaque électriquement conductrice (120), et dans lequel le procédé comprend en outre l'étape consistant à raccourcir les saillies en forme de pilier (166) pour qu'elles affleurent avec une surface extérieure de la couche opaque électriquement conductrice (120).

12. Ensemble connecteur électrique pour moyenne ou haute tension comprenant:
un corps de connecteur, au moins un premier et un deuxième réceptacle de conducteur pour recevoir au moins un premier conducteur (102) et au moins un deuxième conducteur (104) qui doivent être connectés électriquement, et
au moins un premier élément de liaison électrique interchangeable (112, 142, 150) pouvant être retiré dudit corps de connecteur et formé pour établir une connexion électrique entre lesdits premier et second conducteurs (102, 104),
dans lequel ledit corps de connecteur comprend un couvercle de protection selon l'une des revendications 1 à 6.

13. Ensemble connecteur électrique selon la revendication 12, dans lequel ledit corps de connecteur comprend une zone de surveillance de forme tubulaire, dans lequel des première et deuxième fenêtres de rayonnement (128) sont agencée dans ladite zone de surveillance pour s'opposer radialement l'une à l'autre avec par rapport à un axe longitudinal (132) de la zone de surveillance.

14. Ensemble connecteur électrique selon les revendications 12 ou 13, comprenant en outre un deuxième élément de liaison électrique interchangeable (152) fournissant une isolation électrique entre un premier et un deuxième conducteur (102,104), et/ou comprenant en outre un troisième élément de liaison électrique (148) fournissant une isolation électrique entre lesdits premier et deuxième conducteur, et une connexion électrique entre ledit premier conducteur et le potentiel de terre.

15. Procédé de surveillance de l'état connecté d'un ensemble connecteur électrique, selon la revendication 12,
ledit procédé comprenant les étapes suivantes:
transmettre un rayonnement optique (156) à travers ladite première fenêtre de rayonnement (128) pour pénétrer dans le corps du connecteur uniquement au cas où ledit au moins un premier élément de liaison électrique interchangeable (112, 142, 144) n'est pas monté,
détecter, au niveau de la deuxième fenêtre de rayonnement (128), le rayonnement qui pénètre dans le corps de connecteur pour indiquer que ledit au moins un premier élément de liaison électrique interchangeable n'est pas monté.
